(19) Europäisches Patentamt
European Patent Office
Office européen des brevets

(11) **EP 1 029 279 B1**

(12) **EUROPÄISCHE PATENTSCHRIFT**

(45) Veröffentlichungstag und Bekanntmachung des Hinweises auf die Patenterteilung:
**27.09.2006 Patentblatt 2006/39**

(21) Anmeldenummer: **99945865.6**

(22) Anmeldetag: **01.07.1999**

(51) Int Cl.:
***G06F 12/04*** *(2006.01)*

(86) Internationale Anmeldenummer:
**PCT/DE1999/002009**

(87) Internationale Veröffentlichungsnummer:
**WO 2000/002127 (13.01.2000 Gazette 2000/02)**

(54) **DATENSPEICHERVORRICHTUNG**

DATA STORAGE DEVICE

DISPOSITIF DE MISE EN MEMOIRE DE DONNEES

(84) Benannte Vertragsstaaten:
**DE FR GB IT**

(30) Priorität: **03.07.1998 DE 19829836**

(43) Veröffentlichungstag der Anmeldung:
**23.08.2000 Patentblatt 2000/34**

(73) Patentinhaber: **Infineon Technologies AG**
**81669 München (DE)**

(72) Erfinder: **PFAB, Stefan**
**D-82049 Grosshesselohe (DE)**

(74) Vertreter: **Jannig, Peter et al**
**Jannig & Repkow,**
**Patentanwälte,**
**Klausenberg 20**
**86199 Augsburg (DE)**

(56) Entgegenhaltungen:
**EP-A- 0 217 232      WO-A-95/22791**
**US-A- 4 467 443      US-A- 5 307 321**

## Beschreibung

Die vorliegende Erfindung betrifft eine Vorrichtung gemäß dem Oberbegriff des Patentanspruchs 1.

Eine der wichtigsten Eigenschaften, die eine Datenspeichervorrichtung aufweisen muß, besteht darin, daß in dieser gespeicherte Daten so schnell wie möglich ausgelesen werden können. Dies gilt insbesondere dann, wenn es sich bei der Datenspeichervorrichtung um einen Programmspeicher für eine programmgesteuerte Einheit wie beispielsweise einen Mikroprozessor, Mikrocontroller oder dergleichen handelt. Die Datenspeichervorrichtungen, die üblicherweise als Programmspeicher verwendet werden (ROMs, EPROMs, Flash EPROMs, DRABis etc.) sind in der Regel nicht in der Lage, die darin gespeicherten (Befehls-)Daten so schnell auszugeben wie sie moderne programmgesteuerte Einheit abarbeiten können. Deshalb werden häufig schnelle statische RAMs als Zwischenspeicher (Cache) verwendet. Diese Caches ermöglichen es, daß die programmgesteuerte Einheit die benötigten Daten nicht immer aus dem langsamen Programmspeicher holen muß, sondern häufig aus dem schnellen Cache erhalten kann.

Dadurch können insbesondere Programmabschnitte mit linearem (keine Sprünge aufweisenden) Ablauf sehr schnell ausgeführt werden. Dies gilt jedoch nicht oder allenfalls eingeschränkt für Programmabschnitte mit den linearen Ablauf unterbrechenden Befehlen wie beispielsweise Sprungbefehlen und dergleichen. Der nach einem Sprung auszuführende Befehl ist nämlich in vielen Fällen nicht im Cache verfügbar, weshalb in diesen Fällen nach wie vor auf den langsamen Programmspeicher zugegriffen werden muß.

Dabei kommt erschwerend hinzu, daß der Befehl, der nach einem Sprung oder dergleichen aus dem Programmspeicher zu holen ist, häufig nicht vollständig in den Daten enthalten ist, die vom Programmspeicher auf eine Datenausgabe-Anforderung hin ausgegeben werden. Dies kann selbst dann der Fall sein, wenn die Datenmenge, die auf eine Datenausgabe-Anforderung hin ausgegeben wird, mit beispielsweise 4 oder 8 Bytes relativ groß (erheblich größer als die Befehlslänge) ist. In solchen Fällen sind zwei Lesezugriffe auf den Programmspeicher erforderlich, um die den nächsten Befehl repräsentierenden Daten erhalten zu können.

Dies ist ein nicht unerhebliches Problem, zumal in typischen Programmen etwa jeder dritte Befehl ein Sprungbefehl ist.

Das Dokument WO 95/22791 A beschreibt eine Datenspeichervorrichtung gemäß dem Oberbegriff des Patentanspruchs 1. In diesem Dokument ist ein Cache beschrieben, der separate Ausgabepfade für Befehle und Daten aufweist. Der Befehls-Ausgabepfad ermöglicht in einem einzigen Zyklus den Zugriff auf eine Vielzahl von Doppelworten. Genauer gesagt überträgt der Befehls-Ausgabepfad in zwei Zyklen eine gesamte, im beschriebenen Beispiel 16 Bytes umfassende Cache-Zeile. Im ersten Zyklus wird die gesamte Cache-Zeile in ein Instruktionsregister geschrieben, und wählt ein Instruktions-Multiplexer die ersten 8 Bytes der Cache Zeile aus. Im zweiten Zyklus wird der Instruktions-Multiplexer angewiesen, die zweiten 8 Bytes im Instruktionsregsiter auszuwählen. Der Daten-Ausgabepfad ermöglicht in einem einzigen Zyklus den Zugriff auf Daten, die eine Doppelwortgrenze überschreiten und die Lieferung der Daten als ausgerichtete Daten.

Der vorliegenden Erfindung liegt daher die Aufgabe zugrunde, eine Maßnahme zu finden, durch welche die Bereitstellung von Daten, die Folgebefehle nach Sprüngen oder dergleichen repräsentieren, beschleunigt werden kann.

Diese Aufgabe wird erfindungsgemäß durch die im kennzeichnenden Teil des Patentanspruchs 1 beanspruchten Merkmale gelöst.

Aufgrund der geringen gegenseitigen Abstände der auswählbaren Ausgabestartadressen kann - von wenigen Ausnahmen abgesehen - stets eine Ausgabestartadresse zur Anwendung kommen, durch welche die einen Befehl repräsentierenden Daten durch einen einzigen Zugriff aus dem Programmspeicher (die Datenspeichervorrichtung) ausgelesen werden können.

Dadurch kann die Zeit, die erforderlich ist, um Folgebefehle nach Sprüngen oder dergleichen repräsentierende Daten bereitzustellen, auf verblüffend einfache Art und Weise auf ein Minimum reduziert werden.

Die geeignete Wahl der Ausgabestartadresse kann dabei beispielsweise unter Verwendung von nachfolgend als Anpassungsdaten bezeichneten Daten erfolgen, welche zusätzlich neben den sonst üblichen Daten an die Datenspeichervorrichtung angelegt werden, und durch die festgelegt wird, ob und gegebenenfalls in welchem Umfang die zu verwendende Ausgabestartadresse größer oder kleiner als die Adresse ist, die durch die ebenfalls an die Datenspeichervorrichtung angelegten Adreßdaten als Ausgabestartadresse bestimmt wird. Dadurch kann die Ausgabestartadresse äußerst einfach und unter unveränderter Beibehaltung der üblichen Adressierung der Datenspeichervorrichtung dynamisch individuell festgelegt werden.

Vorteilhafte Weiterbildungen der Erfindung sind den Unteransprüchen, der folgenden Beschreibung und den Figuren entnehmbar.

Die Erfindung wird nachfolgend anhand von Ausführungsbeispielen unter Bezugnahme auf die Figuren näher erläutert. Es zeigen

Figur 1   schematisch den Aufbau eines ersten Ausführungsbeispiels der beschriebenen Datenspeichervorrichtung, und

Figur 2    schematisch den Aufbau eines zweiten Ausführungsbeispiels der beschriebenen Datenspeichervorrichtung.

Die nachfolgend näher beschriebenen Datenspeichervorrichtungen sind in einer integrierten Schaltung untergebrachte Halbleiterspeicher, genauer gesagt als Programmspeicher verwendete RAMs, ROMs, EPROMs, Flash-EPROMs oder dergleichen; bei den Datenspeichervorrichtungen kann es sich grundsätzlich jedoch auch um beliebige andere Datenspeichervorrichtungen handeln.

Die Datenspeichervorrichtungen weisen eine Vielzahl von (zur Speicherung jeweils eines Daten-Bits ausgelegten) Speicherzellen auf, welche in bekannter Weise matrixartig zu einem eine Vielzahl von Zeilen und Spalten aufweisenden Speicherzellenfeld verschaltet sind. Dabei erweist es sich hinsichtlich der Zugriffszeit als besonders vorteilhaft, wenn die einzelnen Speicherzellenfeld-Zeilen sehr viele Speicherzellen umfassen. Im betrachteten Beispiel enthalten die Speicherzellenfeld-Zeilen jeweils 256 Speicherzellen; selbstverständlich können pro Speicherzellenfeld-Zeile auch beliebig viel mehr oder weniger Speicherzellen vorgesehen werden.

Beim Auslesen von in der Datenspeichervorrichtung gespeicherten Daten wird jeweils ein eine vorbestimmte Datenmenge umfassendes Datenwort ausgegeben. Im betrachteten Beispiel umfaßt ein Datenwort 64 Bits; selbstverständlich kann ein Datenwort auch mehr oder weniger Bits umfassen.

Die Speicherzellen sind über an die Datenspeichervorrichtung angelegte Adreßdaten und ebenfalls an die Datenspeichervorrichtung angelegte Anpassungsdaten adressierbar. Durch die Adressierung wird festgelegt, ab welcher Speicherzelle beim Beschreiben der Datenspeichervorrichtung Daten in diese eingeschrieben werden bzw. ab welcher Speicherzelle beim Auslesen der Datenspeichervorrichtung in dieser gespeicherte Daten ausgegeben werden. Die Adresse der Speicherzelle, ab welcher beim Auslesen der Datenspeichervorrichtung in dieser gespeicherte Daten ausgegeben werden, wird nachfolgend als Ausgabestartadresse bezeichnet.

Die nachfolgenden Ausführungen beschränken sich auf das Auslesen von Daten aus der Datenspeichervorrichtung. Das Auslesen von Daten aus der Datenspeichervorrichtung wird durch eine Datenausgabe-Anforderung eingeleitet. Auf eine Datenausgabe-Anforderung hin werden von der durch die Adreßdaten und die Anpassungsdaten festgelegten Ausgabestartadresse 64 Datenbits (ein 64-Bit-Datenwort) ausgegeben.

Dabei weisen die auswählbaren Ausgabestartadressen so geringe Abstände voneinander auf, daß die zwischen benachbarten Ausgabestartadressen speicherbare Datenmenge geringer ist als die auf eine Datenausgabe-Anforderung hin ausgegebene Datenmenge.

Durch die an die Datenspeichervorrichtung angelegten Adreßdaten wird die Datenspeichervorrichtung wie üblich adressiert. D.h., daß die durch die Adreßdaten bestimmbaren Ausgabestartadressen in gleichbleibend großen Schritten aufeinanderfolgen, wobei die Schrittweite genau der Anzahl der Bits entspricht, die auf eine Datenausgabe-Anforderung hin ausgegeben wird. Im betrachteten Fall, wo die Daten in Einheiten von 64 Bits eingeschrieben und ausgelesen werden können, bedeutet dies, daß über die Adreßdaten die Adressen der Bits Nummer 0, 64, 128 und 192 einer jeden Speicherzellenfeld-Zeile als Ausgabestartadressen bestimmbar sind.

Durch die an die Datenspeichervorrichtung angelegten Anpassungsdaten wird festgelegt, ob und gegebenenfalls in welchem Umfang die zu verwendende Ausgabestartadresse größer oder kleiner als die durch die Adreßdaten bestimmte Ausgabestartadresse ist. D.h., es kann festgelegt werden, ob die durch die Adreßdaten bestimmte Ausgabestartadresse oder eine mehr oder weniger größere oder kleinere Adresse als Ausgabestartadresse verwendet wird.

Dies läßt sich beispielsweise dadurch bewerkstelligen, daß die Schnittstelle zwischen dem Speicherzellenfeld und den Ausgabeanschlüssen der Datenspeichervorrichtung entsprechend modifiziert wird. Die besagte Schnittstelle besteht bislang aus einem oder mehreren Multiplexern, durch den wahlweise die Bits

```
0 bis x-1
x bis 2x-1
..., oder
(n-1)x bis nx-1
```

der jeweils ausgewählten Speicherzellenfeld-Zeile auf die Ausgabeanschlüsse durchgeschaltet werden, wobei x gleich der Anzahl der Bits pro ausgegebenem Datenwort repräsentiert und im betrachteten Beispiel 64 beträgt, und wobei n die Anzahl der pro Speicherzellenfeld-Zeile speicherbaren Datenworte repräsentiert und im betrachteten Beispiel 4 beträgt.

Durch einen oder mehrere zusätzliche Multiplexer und/oder eine Modifikation der vorhandenen Multiplexer und (zusätzlicher) Ansteuerung derselben durch die Anpassungsdaten wird erreicht, daß wahlweise die Bits

```
0 bis x-1 oder y bis x-1+y
x bis 2x-1 oder x+y bis 2x-1+y
..., oder
(n-1)x bis nx-1 oder (n-1)x+y bis nx-1
```

der jeweils ausgewählten Speicherzellenfeld-Zeile auf die Ausgabeanschlüsse durchgeschaltet werden, wobei der neue Parameter y einen Versatz bzw. Offset gegenüber der durch die Adreßdaten bestimmten Ausgabestartadresse bezeichnet.

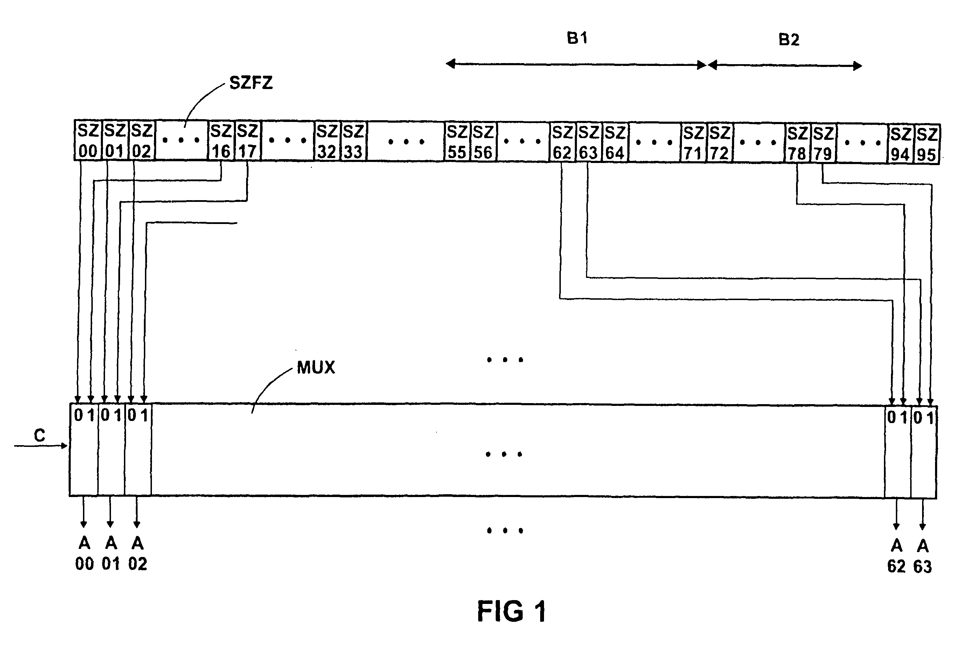

Die praktische Realisierung einer Anordnung, durch welche wahlweise die Bits 0 bis 63 oder die Bits 16 bis 79 einer Speicherzellenfeld-Zeile auf die Ausgabeanschlüsse der Datenspeichervorrichtung durchgeschaltet werden (Offset y = 16), ist in Figur 1 veranschaulicht.

Dabei sind die ausgewählte Speicherzellenfeld-Zeile mit dem Bezugszeichen SZFZ, deren Speicherzellen mit den Bezugszeichen SZ00, SZ01, SZ02, ..., der Multiplexer mit dem Bezugszeichen MUX, und das diesen steuernde Steuersignal mit dem Bezugszeichen C bezeichnet, wobei das den Multiplexer MUX ansteuernde Steuersignal C den Anpassungsdaten entspricht oder auf diesen basiert.

Hat das Steuersignal C des Multiplexers MUX den Wert 0, so werden wie bisher üblich die in den Speicherzellen SZ00 bis SZ63 gespeicherten Daten auf die Ausgabeanschlüsse A00 bis A63 der Datenspeichervorrichtung durchgeschaltet; hat das Steuersignal C des Multiplexers MUX hingegen den Wert 1, so werden die in den Speicherzellen SZ16 bis SZ79 gespeicherten Daten auf die Ausgabeanschlüsse A00 bis A63 der Datenspeichervorrichtung durchgeschaltet.

In beiden Fällen werden auf eine Datenausgabe-Anforderung hin 64 Daten-Bits aus der Datenspeichervorrichtung ausgegeben. Allerdings ist die Herkunft der ausgegebenen Daten verschieden, denn die Ausgabestartadresse ist im Fall C=1 um den Offset (hier 16) größer als die Ausgabestartadresse im Fall C=0.

Die bedarfsweise Verschiebbarkeit der Ausgabestartadresse erweist sich insbesondere dann als vorteilhaft, wenn durch die betreffende Datenausgabe-Anforderung der auf einen Sprungbefehl oder dergleichen folgende Befehl gelesen werden soll und die diesen Befehl repräsentierenden Daten erst an einer Stelle beginnen, die relativ weit hinten in dem normalerweise (ohne Verschiebung der Ausgabestartadresse) ausgegebenen Datenwort liegt. Dann kann nämlich ein Befehl, der über eine normale Datenausgabe-Anforderung nur teilweise geholt werden könnte, durch einen einzigen Zugriff auf die Datenspeichervorrichtung vollständig geholt werden.

Dies ist beispielsweise der Fall, wenn die Speicherzellen SZ55 bis SZ71 den ersten Befehl B1 repräsentieren, der nach einem Sprung oder dergleichen auszuführen ist.

Wollte man den Befehl B1 "normal", d.h. ohne Verschiebung der Ausgabestartadresse holen, müßten zwei Zugriffe auf die Datenspeichervorrichtung erfolgen, denn durch den ersten Zugriff könnte nur das erste Byte des (2-Byte-)Befehls B1 erhalten werden. Holt man den Befehl B1 hingegen mit einer mindestens um ein Byte verschobenen Ausgabestartadresse, so kann der Befehl B1 mit einem einzigen Zugriff auf die Datenspeichervorrichtung vollständig geholt werden.

Der Umfang, in welchem die Ausgabestartadresse durch die Anpassungsdaten verschoben wird, wird im betrachteten Beispiel durch die Beschaltung des Multiplexers MUX festgelegt und kann vorzeichen- und betragsmäßig beliebig festgelegt werden.

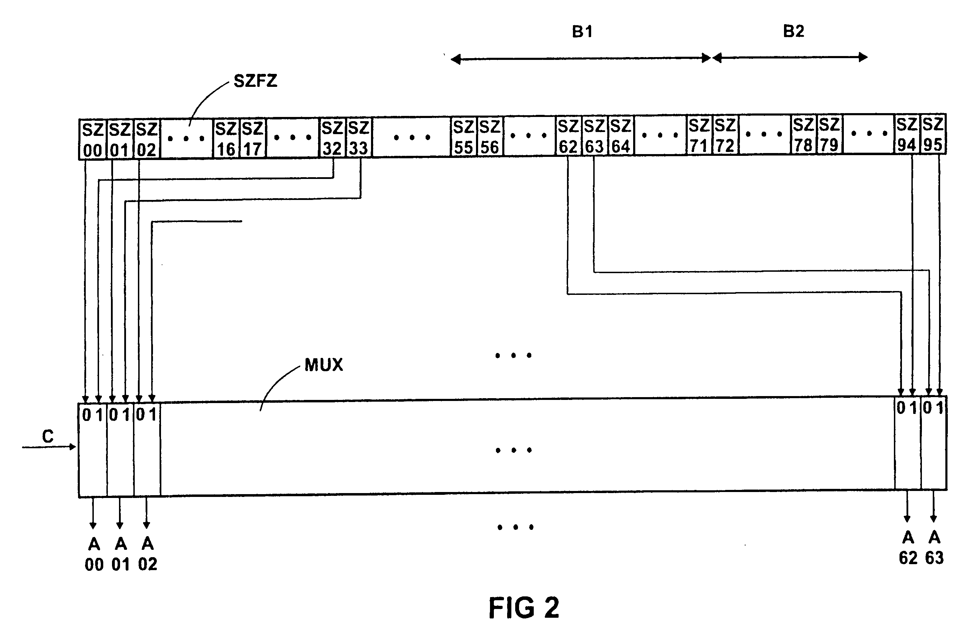

Die praktische Realisierung einer Anordnung, durch welche wahlweise die Bits 0 bis 63 oder die Bits 32 bis 95 einer Speicherzellenfeld-Zeile auf die Ausgabeanschlüsse der Datenspeichervorrichtung durchgeschaltet werden (Offset y = 32), ist in Figur 2 veranschaulicht.

Der Aufbau der Anordnung gemäß Figur 2 entspricht im wesentlichen dem Aufbau der Anordnung gemäß Figur 1; Unterschiede existieren "nur" in der Beschaltung der Eingangsanschlüsse des Multiplexers MUX.

Die Verschiebung des Ausgabestartadresse um 32 Bits erweist sich im betrachteten Beispiel als noch vorteilhafter, weil damit durch einen einzigen Zugriff auf die Datenspeichervorrichtung der auf den Sprungbefehl folgende Befehl B1 und ferner der auf diesen folgende, im betrachteten Beispiel in den Speicherzellen SZ72 bis SZ88 gespeicherte Befehl B2 vollständig erhalten werden können.

Dies bedeutet allerdings nicht, daß ein Offset von 32 generell vorteilhafter ist als andere Offsets. Welcher Offset optimal ist, hängt insbesondere von der Datenmenge, die pro Datenausgabe-Anforderung ausgegeben wird, und von den Längen der auszuführenden Befehle ab.

Die Datenspeichervorrichtung kann auch so aufgebaut werden, daß der verwendete Offset vorzeichen- und/ oder betragsmäßig variierbar ist, so daß der Offset abhängig von den jeweils aktuellen Verhältnissen (unter Verwendung von mehrere Bits umfassenden Anpassungsdaten) individuell ausgewählt werden kann.

Für den Fall, daß der Offset wie bei dem in der Figur 2 veranschaulichten Ausführungsbeispiel genau halb so groß sein soll wie die Anzahl der auf eine Datenausgabe-Anforderung hin ausgegebenen Daten-Bits, können die (bei den in den Figuren 1 und 2 veranschaulichten Beispielen jeweils 1 Bit umfassenden) Anpassungsdaten durch ein zusätzliches (Adreß-)Bit in den an die Datenspeichervorrichtung angelegten Adreßdaten ersetzt werden.

Der Vollständigkeit halber sei erwähnt, daß es für das ordnungsgemäße Funktionieren der Anordnungen gemäß den Figuren 1 und 2 erforderlich ist, daß beim Auslesen von Daten aus der Datenspeichervorrichtung mehr Speicherzellen ausgelesen werden als Daten-Bits auszugeben sind. Da bei den bekannten Datenspeichervorrichtungen in der Regel aber ohnehin jeweils alle Speicherzellen der ausgewählten Speicherzellenfeld-Zeile ausgelesen werden, sind diesbezüglich keine oder jedenfalls keine größeren Modifikationen der Datenspeichervorrichtungen erforderlich.

Ferner sei darauf hingewiesen, daß es beim Lesen von am Anfang und/oder am Ende einer Speicherzellenfeld-Zeile gespeicherten Daten geschehen kann, daß nur ein Teil der ausgegebenen Daten gültig ist. Die Handhabung dieser Besonderheit stellt allerdings kein Problem dar. Daß die ausgegebenen Daten nur teilweise gültig sind, kann beispielsweise durch eine entsprechende Kennung (Flag) signalisiert werden.

Es dürfte auch einleuchten, daß in Fällen, in denen die einen Befehl repräsentierenden Daten über das Ende einer Speicherzellenfeld-Zeile hinausgehen (in der nächsten Speicherzellenfeld-Zeile fortgesetzt werden), nach wie vor zwei Zugriffe auf die Datenspeichervorrichtung erfolgen müssen, um den betreffenden Befehl vollständig zu holen.

Nichtsdestotrotz kann durch eine wie beschrieben oder ähnlich aufgebaute Datenspeichervorrichtung die Anzahl der Zugriffe, die erforderlich ist, um bestimmte Daten auszulesen, auf ein Minimum reduziert werden.


Bezugszeichenliste

SZFZ    Speicherzellenfeld-Zeile

SZxx    Speicherzelle xx innerhalb einer Speicherzellenfeld-Zeile

B1    erster Befehl, der nach einem Sprung auszuführen ist

B2    zweiter Befehl, der nach einem Sprung auszuführen ist

MUX    Multiplexer

C    Multiplexer-Steuersignal (= Anpassungsdaten)

Ayy    Ausgabeanschluß yy der Datenspeichervorrichtung


**Patentansprüche**

1. Datenspeichervorrichtung, die auf eine Datenausgabe-Anforderung hin ab einer ausgewählten Ausgabestartadresse gespeicherte Daten ausgibt,

- wobei die Datenspeichervorrichtung ein eine Vielzahl von Speicherzellen (SZ) umfassendes Speicherzellenfeld und einen mit dem Speicherzellenfeld verbundenen Multiplexer (MUX) enthält, wobei die aus der Datenspeichervorrichtung ausgegebenen Daten (A00 - A63) im Speicherzellenfeld gespeicherte und vom Multiplexer (MUX) durchgeschaltete Daten sind, und
- wobei die auswählbaren Ausgabestartadressen so geringe Abstände voneinander aufweisen, daß die zwischen benachbarten Ausgabestartadressen speicherbare Datenmenge geringer ist als die auf eine Datenausgabe-Anforderung hin aus der Datenspeichervorrichtung ausgegebene Datenmenge,

**dadurch gekennzeichnet,**

- **daß** die Datenspeichervorrichtung ein Programmspeicher ist,
- **daß** der Multiplexer (MUX) so angesteuert wird, daß durch diesen wahlweise entweder ab einer ersten Ausgabestartadresse gespeicherte Daten oder ab einer zur ersten Ausgabestartadresse benachbarten zweiten Ausgabestartadresse gespeicherte Daten durchgeschaltet werden, und
- **daß** der Multiplexer (MUX) so angesteuert wird, daß dieser die ab der zweiten Ausgabestartadresse gespeicherten Daten durchschaltet, wenn der aus der Datenspeichervorrichtung auszulesende Befehl (B1) nicht vollständig in den Daten enthalten ist, die aus der Datenspeichervorrichtung ausgegeben werden würden, wenn der Multiplexer (MUX) so angesteuert werden würde, daß dieser die ab der ersten Ausgabestartadresse gespeicherten Daten durchschaltet.

2. Datenspeichervorrichtung nach Anspruch 1,
**dadurch gekennzeichnet,**
**daß** die Bestimmung der zu verwendenden Ausgabestartadresse unter Berücksichtigung von an die Datenspeichervorrichtung angelegten Adreßdaten erfolgt.

3. Datenspeichervorrichtung nach Anspruch 2,
**dadurch gekennzeichnet,**
**daß** die Bestimmung der zu verwendenden Ausgabestartadresse unter zusätzlicher Berücksichtigung von zur Steuerung des Multiplexers (MUX) verwendeten Anpassungsdaten (C) erfolgt, wobei die Anpassungsdaten (C) definieren, ob und gegebenenfalls in welchem Umfang die zu verwendende Ausgabestartadresse größer oder kleiner als die Adresse ist, die durch die Adreßdaten definiert wird.

4. Datenspeichervorrichtung nach einem der vorhergehenden Ansprüche,
**dadurch gekennzeichnet,**
**daß** die erste Ausgabestartadresse die Adresse ist, die durch die an die Datenspeichervorrichtung angelegten Adreßdaten repräsentiert wird.

5. Datenspeichervorrichtung nach einem der vorhergehenden Ansprüche,
**dadurch gekennzeichnet,**
**daß** die zweite Ausgabestartadresse um einen durch die Beschaltung des Multiplexers (MUX) festgelegten Umfang größer oder kleiner als die erste Ausgabestartadresse ist.

**Claims**

1. Data storage apparatus which, upon a data output request, outputs data stored from a selected output start address onward,

- where the data storage apparatus contains a memory cell array, comprising a multiplicity of memory cells (SZ), and a multiplexer (MUX) connected to the memory cell array, the data (A00 - A63) which are output from the data storage apparatus being data which are stored in the memory cell array and which are switched through by the multiplexer (MUX), and
- where the selectable output start addresses are at such short intervals from one another that the volume of data which can be stored between adjacent output start addresses is smaller than the volume of data which is output from the data storage apparatus upon a data output request,

**characterized**

- **in that** the data storage apparatus is a program store,
- **in that** the multiplexer (MUX) is actuated such that it selectively switches through either data stored from a first output start address onward or data stored from a second output start address, which is adjacent to the first output start address, onward, and
- **in that** the multiplexer (MUX) is actuated such that it switches through the data stored from the second output start address onward if the command (B1) which is to be read from the data storage apparatus is not fully contained in the data which would be output from the data storage apparatus if the multiplexer (MUX) were to be actuated such that it switches through the data stored from the first output start address onward.

2. Data storage apparatus according to Claim 1,
**characterized**
**in that** the output start address which is to be used is determined taking into account address data applied to the data storage apparatus.

3. Data storage apparatus according to Claim 2,
**characterized**

**in that** the output start address which is to be used is determined additionally taking into account adaptation data (C) which are used to control the multiplexer (MUX), the adaptation data (C) defining whether and possibly to what extent the output start address which is to be used is larger or smaller than the address which is defined by the address data.

4. Data storage apparatus according to one of the preceding claims,
   **characterized**
   **in that** the first output start address is the address which is represented by the address data applied to the data storage apparatus.

5. Data storage apparatus according to one of the preceding claims,
   **characterized**
   **in that** the second output start address is larger or smaller than the first output start address by an extent which is stipulated by the interconnection of the multiplexer (MUX).


**Revendications**

1. Dispositif d'enregistrement de données qui, sur une demande d'émission de données, délivre les données enregistrées à partir d'une adresse de début d'émission choisie,

   - le dispositif d'enregistrement de données comprenant un réseau de cellules de mémoire comprenant un grand nombre de cellules de mémoire (SZ) ainsi qu'un multiplexeur (MUX) relié avec le réseau de cellules de mémoire, les données émises depuis le dispositif d'enregistrement de données (A00 - A63) étant des données enregistrées dans le réseau de cellules de mémoire et commutées par le multiplexeur (MUX), et
   - les adresses de début d'émission sélectionnables présentant des écarts si faibles entre elles que le volume de données pouvant être enregistré entre des adresses de début d'émission voisines est inférieur au volume de données délivré depuis le dispositif d'enregistrement de données sur une demande d'émission de données,

   **caractérisé en ce que**

   - le dispositif d'enregistrement de données est une mémoire de programmes,
   - le multiplexeur (MUX) est commandé de telle sorte qu'il commute, au choix, soit les données enregistrées à partir d'une première adresse de début d'émission, soit les données enregistrées à partir d'une deuxième adresse de début d'émission voisine de la première adresse de début d'émission, et
   - le multiplexeur (MUX) est commandé de telle sorte que celui-ci commute les données enregistrées à partir de la deuxième adresse de début d'émission lorsque l'instruction (B1) à charger depuis le dispositif d'enregistrement de données n'est pas entièrement incluse dans les données qui auraient été délivrées par le dispositif d'enregistrement de données si le multiplexeur (MUX) avait été commandé de telle sorte que celui-ci commute les données enregistrées à partir de la première adresse de début d'émission.

2. Dispositif d'enregistrement de données selon la revendication 1, **caractérisé en ce que** la détermination de l'adresse de début d'émission à utiliser s'effectue en tenant compte des données d'adresse appliquées au dispositif d'enregistrement de données.

3. Dispositif d'enregistrement de données selon la revendication 2, **caractérisé en ce que** la détermination de l'adresse de début d'émission à utiliser s'effectue en tenant également compte des données d'adaptation (C) utilisées pour la commande du multiplexeur (MUX), les données d'adaptation (C) définissant si et éventuellement dans quelle mesure l'adresse de début d'émission à employer est supérieure ou inférieure à l'adresse qui est définie par les données d'adresse.

4. Dispositif d'enregistrement de données selon l'une des revendications précédentes, **caractérisé en ce que** la première adresse de début d'émission est l'adresse qui est représentée par les données d'adresse appliquées au dispositif d'enregistrement de données.

5. Dispositif d'enregistrement de données selon l'une des revendications précédentes, **caractérisé en ce que** la deuxième adresse de début d'émission est supérieure ou inférieure à la première adresse de début d'émission d'un montant déterminé par la commutation du multiplexeur (MUX).

FIG 1

FIG 2